# EUROPEAN PATENT SPECIFICATION

(11) **EP 2 105 799 B1**
(45) Date of publication and mention of the grant of the patent: **22.02.2012**
(21) Application number: 08102922.5
(22) Date of filing: 26.03.2008
(51) Int. Cl.: G03F 7/38, G03F 7/32

(54) **A method for preparing lithographic printing plates**
Verfahren zur Herstellung lithographischer Druckplatten
Procédé pour préparer des plaques d'impression lithographiques

(43) Date of publication of application: 30.09.2009
(73) Proprietor: Agfa Graphics N.V., 2640 Mortsel (BE)
(72) Inventor: Hendrikx, Peter, 2640, Mortsel (BE); Williamson, Alexander, 2640, Mortsel (BE); Van Damme, Marc, 2640, Mortsel (BE)

(56) References cited:
- WO-A-2007/057336
- US-A1- 2002 115 022

## Description

### FIELD OF THE INVENTION

The present invention relates to a method of preparing a photopolymer printing plate.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, typically paper. In conventional, so-called "wet" lithographic printing, ink as well as an aqueous fountain solution (also called dampening liquid) are supplied to the lithographic image consisting of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing only ink is supplied to the master.

The so-called "analogue" printing plates are generally obtained by first applying a so-called computer-to-film (CtF) method, wherein various pre-press steps such as typeface selection, scanning, color separation, screening, trapping, layout and imposition are accomplished digitally and each color selection is transferred to graphic arts film using an image-setter. After processing, the film can be used as a mask for the exposure of an imaging material called plate precursor and after plate processing, a printing plate is obtained which can be used as a master. Since about 1995, the so-called "computer-to-plate" (CtP) method has gained a lot of interest. This method, also called "direct-to-plate", bypasses the creation of film because the digital document is transferred directly to a printing plate precursor by means of a plate-setter. A printing plate precursor for CtP is often called a digital plate.

Digital plates can roughly be divided in three categories: (i) silver plates, working according to the silver salt diffusion transfer mechanism; (ii) photopolymer plates containing a photopolymerizable composition that hardens upon exposure to light and (iii) thermal plates of which the imaging mechanism is triggered by heat or by light-to-heat conversion.

Photopolymer plate precursors can be sensitized for blue, green or red light (i.e. wavelength range between 450 and 750 nm), for violet light (i.e. wavelength range between 350 and 450 nm) or for infrared light (i.e. wavelength range between 750 and 1500 nm). Lasers have become the predominant light source used to expose photopolymer printing plate precursors. Typically, an Ar laser (488 nm) or a FD-YAG laser (532 nm) can be used for exposing a visible light sensitized photopolymer plate precursor. The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material. For this reason, photopolymer plates having their maximal sensitivity in the 350 nm to 450 nm region have been developed during the last years. An advantage of violet photopolymer technology is the reliability of the laser source and the possibility of handling the non-developed photopolymer plate precursors in yellow safelight conditions. The use of infrared lasers also became more important in the last years, for example the Nd-YAG laser emitting around 1060 nm but especially the infrared laser diode emitting around 830 nm. For these laser sources, infrared sensitive photopolymer plate precursors have been developed. The major advantage of infrared photopolymer technology is the possibility to handle the non-developed photopolymer plate precursors in daylight conditions.

After exposure of a photopolymer plate precursor a rather complex processing is typically carried out. A pre-heat step is usually carried out to enhance the polymerization and/or crosslinking in the imaged areas. Then during a pre-wash step, typically with plain water, the protective layer of the photopolymer plate precursor is removed. After the pre-wash step the non-imaged parts are removed in a development step, typically with an alkaline developer having a pH > 10. After the development step, a rinse step, typically with plain water, and a gumming step is carried out. Gumming protects the printing plate during the time between development and printing against contamination for example by oxidation, fingerprints, fats, oil or dust, or against damage, for example during handling of the plate. Such processing of photopolymer plates is usually carried out in automatic processors having a pre-heat section, a pre-wash section, a development section, a rinse and gum section and a drying section.

To avoid this complex, time consuming and environmentally unfriendly processing of photopolymer plate precursors several alternatives have been described.

In US 6 027 857, US 6 171 735, US 6 420 089, US 6 071 675, US 6 245 481, US 6 387 595, US 6 482 571, US 6 576 401 and US 6 548 222 a method is disclosed for preparing a lithographic printing plate wherein a photopolymer plate precursor, after image-wise exposure, is mounted on a press and processed on-press by applying ink and fountain to remove the unexposed areas from the support. Also US2003/16577 and US2004/13968 disclose a method wherein a plate precursor comprising a photopolymerizable layer can be processed on-press with fountain and ink or with a non-alkaline aqueous developer.

In W02005/111727 a method is disclosed wherein a photopolymer plate precursor is developed by applying a gum solution to the plate. The gum solution, for example a gum solution used in the gumming step of a conventional processing method, is used for both developing, i.e. removing the non-imaged parts of the coating, and gumming the exposed photopolymer plates. So, according to this method, no pre-wash step, no rinse step and no additional gum step is needed anymore during processing. This method provides a simplified processing of photopolymer plate precursors and in addition, since on the one hand no highly alkaline developer is used anymore and on the other hand much less processing liquids are used altogether (no pre-wash, no rinse and no separate gum), provides an environmentally more friendly processing. WO2007/057334 also discloses a method to prepare photopolymer plates wherein the development is carried out in a gum solution. However, in this method a pre-wash is carried out before development with the gum solution. Other methods, all using a gum solution to develop photopolymer plates, are disclosed in for example WO2007/057335 and W02007/057349. W02007/057348 and WO2007/057336 disclose a method wherein a gum solution is used to develop a photopolymer plate and wherein a pre-heat step is carried out after exposure and before development. In WO2007/057336 the pre-heat section and the development section are combined in one single apparatus. Development with the gum solution in the above mentioned methods is usually carried out at room temperature.

A problem observed with a method of preparing photopolymer plates wherein immediately after a pre-heat step development is carried out with a gum solution, especially when both pre-heat and development are combined in one single apparatus, is an inconsistency of the lithographic properties of the obtained printing plates. While not changing the exposure conditions, it has been observed that when a substantial number of photopolymer plates are produced, the individual plates may have different properties such as different dot rendering, especially in the highlights, and a different press life.

It has now been found that this inconsistency is the result of fluctuations of the temperature of the gum solution. When the time between pre-heat and development is limited, as in practical conditions, the pre-heated printing plates upon entering the gum solution increase the temperature of the gum solution. When several printing plates are processed within a short time, such an increase in temperature of the gum solution may become substantial, for example more than 10°C and even up to 20°C. During the time wherein no printing plates are produced the temperature of the gum solution will decrease again. These fluctuations in temperature may give rise to inconsistent lithographic properties of the obtained printing plates, which is of course unacceptable in practice.

In conventional processing of photopolymer plate precursors, this problem is not observed since the pre-heated printing plates are first subjected to a pre-wash before entering the developing section.

Typically conventional processors have some means, present in the development section, to control the temperature of the developer, i.e. heating elements to increase and cooling means to decrease the temperature of the developer. These conventional means are however not sufficient to control the temperature of the developer when the printing plate precursor, after pre-heat, immediately enters the developer, i.e. without carrying out a pre-wash. Providing conventional processors with more efficient means in the development section to cope with the increases in temperature as described above due to the absence of a pre-wash between pre-heat and development of the printing plate precursor, would result in a substantial increase in cost price of such conventional processors.

### SUMMARY OF THE INVENTION

It is an object of the present invention to provide a method of preparing photopolymer printing plates wherein after a pre-heat step the printing plate precursors are developed with a gum solution with which printing plates having consistent lithographic properties are obtained.

This object is realised by the method of claims 1 to 12 wherein between the pre-heat step and the development step an accelerated cooling of the printing plate precursor is carried out.

Preferred embodiments of the present invention are defined in the dependent claims.

### BRIEF DESCRIPTION OF THE DRAWINGS

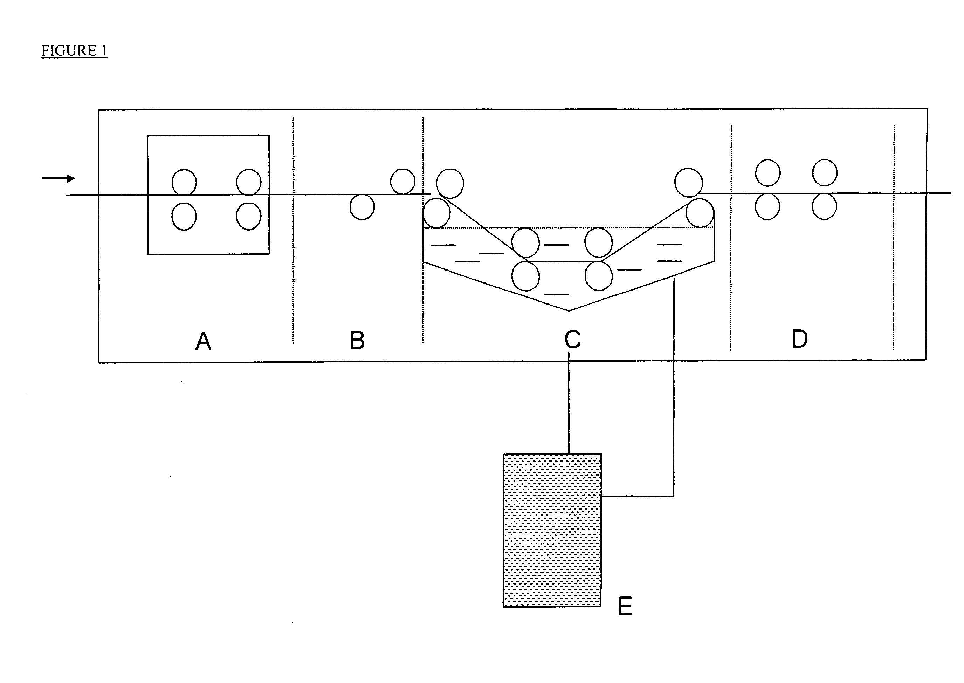

Figure 1 is a schematic drawing of an embodiment of an automatic processor adapted to be used in the method of preparing printing plates according to the present invention.

### DETAILED DESCRIPTION OF THE INVENTION

The present invention provides a method of preparing a lithographic printing plate comprising the steps of:
- providing a lithographic printing plate precursor, the precursor comprising a photopolymerizable coating provided on a hydrophilic support;
- image-wise exposing the precursor;
- pre-heating the exposed precursor;
- developing the exposed precursor in a gum solution;
characterized in that after pre-heating and before developing the precursor an accelerated cooling of the precursor is carried out and the cooling does not essentially remove a part of the coating of the precursor.

### Pre-heat

Providing a pre-heat step after exposure and before processing of a photopolymer printing plate precursor is well known in the art. The pre-heat treatment accelerates the polymerization and/or crosslinking in the imaged parts of the precursor, thereby increasing the durability and improving the uniformity of the hardness of the imaged parts. This may result in an increased runlength, i.e. number of high quality prints that can be made with a single printing plate. During pre-heat, the plate is typically kept at a plate surface temperature, measured on the back side of the plate, ranging from 70°C to 150°C for a period of one second to 5 minutes, preferably from 80°C to 140°C for 5 seconds to 1 minute, more preferably from 90°C to 130°C for 10 seconds to 30 seconds. The back side of the plate is that side of the support that is opposite to the side of the support whereupon the photopolymerizable coating is applied.

The time between exposure and pre-heat is preferably less than 10 minutes, more preferably less than 5 minutes, most preferably less than 1 minute. There is no particular time limit before the pre-heat may start after exposure. Typically, the pre-heat is carried out as soon as possible after exposure, i.e. within the time needed to transport the plate from the exposure unit to the pre-heat section. Examples of heating means that may be used in the pre-heat section include a conventional convection oven, IR lamps, UV lamps, an IR laser, IR tiles, a microwave apparatus or heated rollers, for example metal rollers.

The temperature values referred to above are measured on the back side of the plate. During the pre-heat treatment, especially when using IR tiles, temperatures at the surface of the coating may reach substantially higher values.

To minimize the rise in temperature of the developing solution, due to the pre-heat immediately before development, a moderate pre-heat may be used in the method of the present invention. Such a moderate pre-heat may be carried out at a plate surface temperature ranging from 30°C to 90°C, more preferably from 40°C to 80°C, most preferably from 50°C to 70°C. To enable the use of such a moderate pre-heat treatment and still realize a sufficient press life of the obtained printing plate, an especially designed printing plate precursor may be used, for example comprising adhesion promoting agents as disclosed in WO2007/05733 or comprising a binder having a low Tg as disclosed in EP-A 1 757 981.

### Accelerated cooling

The accelerated cooling referred to in the present invention means that the printing plate precursor upon leaving the pre-heat section is cooled at a higher rate than under ambient conditions. This implies the use of special means to obtain such an accelerated cooling. The cooling does not essentially remove a part of the coating of the precursor. Preferably at most 25 %, more preferably at most 10 %, most preferably at most 5 %, particular preferred none of the coating is removed during the accelerated cooling.

A preferred way of achieving the accelerated cooling is the use of an air flow. The air flow may be directed on the top side or on the back side of the plate precursor or on both. The air may have the ambient temperature or may be cooled, i.e. having a temperature that is less than the ambient temperature. Any means capable of generating an air flow on the plate precursor may be used. The air flow may be directed on the plate precursor by means of an air knife, one or more air fans or one or more air nozzles. When cooling is carried out with ambient air, the source of which is situated within the processor housing, the cooling may become less effective as more and more plates are processed consecutively, since the ambient air within the processor housing may increase in temperature. It is therefore preferred to use air from outside the processor housing for the accelerated cooling.

Another way to achieve the accelerated cooling is contact cooling for example by cooled transport rollers or by contacting the precursor with a cooled platen. Such a contact cooling may be incorporated in an automatic processor between the pre-heat and the development section. The cooled transport rollers or platen may contact the top side or the back side of the plate precursor or both. The rollers may be cooled by circulating a fluid through the inside of the rollers or by contacting their outer side with a fluid, preferably a circulating fluid. The fluid may have ambient temperature or a lower temperature.

Still another manner to achieve the accelerated cooling is applying, for example spraying, jetting or coating, a fluid on the plate precursor. It is preferred that the coating of the printing plate precursor does not substantially dissolve in the cooling fluid used. Again, the fluid may be applied on the top side or on the back side of the plate precursor or on both. The applied fluid may be at ambient temperature or may be at a temperature lower than ambient temperature. The fluid may be for example a low boiling solvent. Either the lower temperature and/or the evaporation of such a low boiling solvent may induce accelerated cooling. The applied fluid may not have an adverse effect on the lithographic properties of the obtained printing plates. The fluid may preferably be collected after application to the plate and reused.

Liquid nitrogen may be used in the accelerated cooling. It may be applied as a liquid on the plate precursor, upon which it will immediately evaporate, or as a vapour.

Still another means to achieve accelerated cooling is applying a solid having a temperature lower than ambient temperature on the plate precursor, for example dry ice, i.e. solid C0₂. When dry ice is used, upon applying it on the plate precursor it will sublime. Dry ice vapour may also be used to cool the plate precursor.

Different means described above to achieve an accelerated cooling may be combined. Depending on the number of plates produced within a given time interval, a different cooling means or a combination of different cooling means may be necessary.

Preferably the accelerated cooling results in a temperature of the plate precursor, just before entering the developing section, that corresponds with the temperature of the gum solution used to develop the plate precursor. Preferably the accelerated cooling results in a temperature of the precursor, just before entering the developing section, of not higher than 50°C, more preferably not higher than 40°C, most preferably not higher than 30°C.

### Development

Development is carried out with a gum solution. During development, an optional overcoat and the non-imaged areas of an image-recording layer are removed. Development is preferably carried out in an automatic processor using spray or dip development. Spray development involves spraying a developing solution on the plate precursor, for example with one or more spray bars. Dip development involves immersion of the plate into a developing solution. The development may be a batch development, i.e. development is carried out with a batch of developer until development is no longer sufficient. At that moment a new batch of developer is introduced in the processor. Development may also be carried out with regeneration of the developer, whereby a given amount of fresh developer is added to the development solution as function of the number of plates already developed. The composition and/or concentration of the fresh developer added during regeneration may be the same or different to that of the initial developer.

The developing step with the gum solution may be combined with mechanical rubbing, preferably by one or more rotating brushes, to better remove the non-imaged parts of an image-recording layer. Preferred rotating brushes are described in US2007/0184387 (paragraphs [0255] to [0257]) and EP-A 1 755 002 (paragraphs [0025] to [0034]). Good results may also be obtained with "flat" brushes. These "flat" brushes may have a width of for example 5.0 to 10 cm and may be equipped with polypropylene or nylon bristles. The length of the bristles may be from 5 to 15 mm. Typically, these "flat" brushes are rubbing the plate precursor by moving back and forth in a direction perpendicular to the plate conveying direction through the processor. Rubbing may be realized by up to 120 movements per minute.

A gum solution is essentially an aqueous solution comprising a surface protective compound capable of protecting the lithographic image of a printing plate against contamination. Suitable examples of such compounds are film-forming hydrophilic polymers or surfactants. A layer that remains on the plate after development with the gum solution preferably comprises more than 0.01 g/m² of a surface protective compound.

The gum solution may be supplied as a ready-to-use developer or as a concentrated solution, which is diluted by the end user with water to a ready-to-use developer according to the instructions of the supplier: typically 1 part of the gum is diluted with 1 to 10 parts of water.

A preferred composition of the gum solution is disclosed in WO2005/111727 (page 6, line 5 to page 11, line 35) and EP-A 1 621 339 (paragraphs [0014] to [0061]).

Preferred surfactants are for example block copolymers based on ethylene oxide and propylene oxide such as the commercially available Pluronic^{®} surfactants such as Pluronic 9400. Other preferred surfactants are tristyrylphenol ethoxylates such as the Emulsogen^{®} surfactants, for example Emulsogen TS160 or TS200. Highly preferred, a combination of both these surfactants is used.

Besides the surface protective compound the gum solution preferably comprises a salt formed by reaction of an acid, containing a phosphorous atom, with a di- or tri-alkanolamine as disclosed in the unpublished EP-A 07 108 228.3 (filed on 2007-05-15).

Development is tyically carried out at temperatures of the developing solution between 20°C and 50°C, preferably between 20°C and 40°C, most preferably between 20°C and 30°C. In the method according to the present invention, the temperature of the developing solution changes preferably not more than 15°C, more preferably not more than 10°C, most preferably not more than 5°C.

When the time between the preparation of the printing plate and mounting that printing plate on a press to start printing is sufficiently short so that no severe contamination may take place, the development may be carried out with any aqueous solution having preferably a pH between 3 and 9, even plain water. Also commonly used press room chemicals, for example fountain solutions or aqueous plate cleaners and/or conditioners may be used, if necessary after proper dilution.

### Processing apparatus

The method of the present invention comprises a pre-heat step and a development step characterized in that after pre-heating and before developing the precursor an accelerated cooling of the precursor is carried out. Preferably these steps are integrated in a dedicated automatic processor. Such a dedicated processor, essentially comprising a pre-heat section, an accelerated cooling section, a development section and a drying section, is compared to conventional processors of photopolymer plates, less complex and needs less floor space.

In Figure 1, a schematic drawing of an embodiment of an automatic processor adapted to be used in the method of preparing printing plates according to the present invention is shown.

The automatic processor has four sections: section A is the pre-heat section; section B is the accelerated cooling section; section C is the developing section and section D is the drying section. An exposed printing plate precursor is automatically transported between the different sections, starting with the pre-heat section A. According to another embodiment, an exposure unit may also be incorporated in the automatic processor, i.e. an exposure section before the pre-heat section.

In the development section C, the precursor is developed in a dip tank using a gum solution E. The solution is typically kept at room temperature, but a higher temperature such as 30°C or 40°C, may also be implemented by means of proper heating elements.

Between the development section C and the pre-heat section A an accelerated cooling section B is provided to enable an accelerated cooling of the pre-heated precursor before entering the development section C. In this cooling section, the cooling means described above are implemented.

After the development section C, a drying section D is provided to ensure that the printing plates are substantially dry upon leaving the automatic processor. Any conventional drying means, at present used in conventional processing units may be used in the drying section.

As described above, an especially adapted automatic processor has some advantages over a conventional photopolymer processor, i.e. is less complicated and requires less floor space. However, since a lot of conventional processors are available on the market, these processors may also be used to carry out the method of the present invention, after proper adaptation. A conventional processor comprises a pre-heat section, a pre-wash section, a developing section, a rinse and gum section and a drying section. To adapt such a processor to the present invention, the pre-wash section and/or the rinse and gum section may be deactivated. An accelerated cooling is carried out between the pre-heat section and the development section.

It has been observed that when a conventional processor is adapted to carry out the method of the present invention, transport rollers in contact with the top side of the plates, i.e. the side carrying a photopolymerizable coating, running dry and positioned after the development section, for example between the development section and the non-active rinse and gum section, may adversely influence the quality of the obtained printing plates. To avoid such problems, those rollers may be wetted by applying water or preferably a gum solution, most preferably the same gum solution used as developer, to those rollers. The solution may be applied to the rollers with a spray bar and collected in a drip tank/tray and reused. The solution may be applied directly onto the rollers or via an additional contact roller. Such a contact roller may supply the solution to more than one transport rollers.

### Photopolymer printing plate precursor

Any photopolymer printing plate precursor capable of being developed with a gum solution may be used in the present invention. The photopolymer printing plate precursors are preferably sensitized for violet light, i.e. for light having a wavelength ranging from 350 nm to 450 nm, or for infrared light, i.e. light having a wavelength ranging from 750 nm to 1500 nm.

A typical photopolymer printing plate precursor typically comprises a photopolymerizable coating provided on a hydrophilic support.

The support is preferably a grained and anodized aluminum support, well known in the art. Suitable supports are for example disclosed in EP-A 1 843 203 (paragraphs [0066] to [0075]). The grained and anodized aluminum support may be subjected to so-called post-anodic treatments, for example a treatment with polyvinylphosphonic acid or derivatives thereof, a treatment with polyacrylic acid, a treatment with potassium fluorozirconate or a phosphate, a treatment with an alkali metal silicate, or combinations thereof. Besides an aluminum support, a plastic support, for example a polyester support, provided with one or more hydrophilic layers may also be used.

The coating provided on a hydrophilic support comprises a photopolymerizable layer, also referred to as the image-recording layer. The coating may further comprise an overcoat and/or an undercoat, the latter also referred to as an intermediate layer or an interlayer.

The overcoat, provided on the photopolymerizable image-recording layer, also referred to as a toplayer or a protective layer, acts as an oxygen barrier layer. Preferred binders which can be used in the top layer are disclosed in WO2005/02919 (page 36 line 3 to page 39 line 25), US 2007/0020563 (paragraph [0158]) and EP 1 288 720 (paragraphs [0148] and [0149]). The most preferred binders for the overcoat are polyvinylalcohol and polyvinylpyrrolidone.

The photopolymerizable layer or image-recording layer typically comprises at least one polymerizable monomer or oligomer, at least one polymeric binder, a photo-initiator and a sensitizer. The photo-initiator - sensitizer system is choosen as function of the exposure wavelength. The photopolymerizable layer may further comprise a contrast dye or pigment, an polymerization inhibitor, a chain transfer agent, adhesion promoting agents interacting with the aluminum surface and other ingredients which may further optimize the properties of the printing plate precursors.

The coating may also comprise one or more intermediate layer, provided between the photopolymerizable image-recording layer and the support. Such an intermediate layer may further optimize the interaction between the image-recording layer and the support, i.e. enable the complete removal of non-imaged parts and a sufficient adhesion of the imaged parts of the image-recording layer.

Preferred violet sensitive printing plate precursors are disclosed in WO2005/111727 WO2005/029187 WO2007/113083 WO2007/057333 WO2007/05744 and the unpublished EP-As 07 108 955, 07 108 957 and 07 108 953, all filed on 25-05-2007. Other violet sensitive printing plate precursors that may be used in the method of the present invention are those disclosed in EP-A 1 793 275, US2007/0184387 and EP-A 1 882 585.

Preferred IR sensitive printing plate precursors are disclosed in WO2005/111727, EP-As 1 788 448 and 1 788 449 and the unpublished EP-A 07 120 845 (filed on 2007-11-16). Other IR sensitive printing plate precursors that may be used in the method of the present invention are those disclosed in EP-As 1 602 982, 1 621 339, 1 630 618 and 1 695 822.

### EXAMPLES

### MATERIALS

All materials used in the examples were readily available from standard sources such as Aldrich Chemical Co. (Belgium) and Acros (Belgium) unless otherwise specified.
• PVA-1: partially hydrolyzed poly(vinyl alcohol); degree of saponification is 88 mol %; viscosity of a 4 wt % aqueous solution at 20 °C is 4 mPa•s; available as MOWIOL 4/88 from Kururay.
• PVA-2: fully hydrolyzed poly(vinyl alcohol); degree of saponification is 98 mol %; viscosity of an aqueous solution of 4 wt % at 20 °C is 4 mPa•s; available as MOWIOL 4/98 from Kururay.
• Acticide: Acticide LA 1206, a biocide commercially available from THOR.
• Lutensol A8: 90 wt % solution of a surface active agent, commercially available from BASF.
• Advantage S: a vinylpyrrolidone-vinylcaprolactam-dimethylaminoethyl methacrylate copolymer commercially available from ISP.
• FST426R: a solution containing 88.2 wt % of a reaction product from 1 mole of 2,2,4-trimethyl-hexamethylenediisocyanate and 2 moles of hydroxyethylmethacrylate (kinematic viscosity 3.30 mm²/s at 25 °C).
• Mono Z1620: a solution in MEK containing 30.1 wt % of a reaction product from 1 mole of hexamethylenediisocyanate, 1 mole of 2-hydroxyethylmethacrylate and 0.5 mole of 2-(2-hydroxyethyl-piperidine (kinematic viscosity 1.7 mm²/s at 25 °C).
• Heliogene Blue: dispersion in Dowanol PM/MEK/γ-butyrolactone containing 5 wt % of Heliogen blau D7490 pigment and 2.5 wt % of KL7177 and 2.5 wt % KOMA30 NEU as dispersants. Heliogen blau D7490 is commercially available from BASF.
• KL7177, methacrylic acid - metylmethacrylate copolymer, commercially available from Clariant
• Hostanox 03: a phenolic antioxidant, commercially available from CLARIANT.
• HABI: 2-(2-chlorophenyl)-4,5-diphenyl bisimidazole, commercially available from SUMITOMO.
• MBT: 2-mercaptobenzthiazole.
• Tegoglide 410: a polydimethylsilixane-polyether surfactant commercially available from GOLDSCHMIDT.
• Sensitizer: a violet sensitizer mixture consisting of the following compounds:

| |
|---|
| 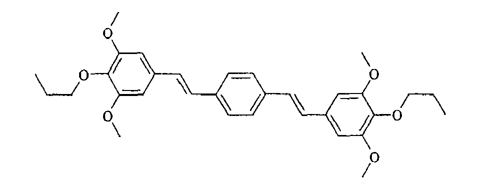 |
| 15 wt.% |
| 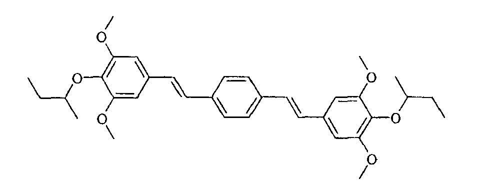 |
| 38 wt.% |
| 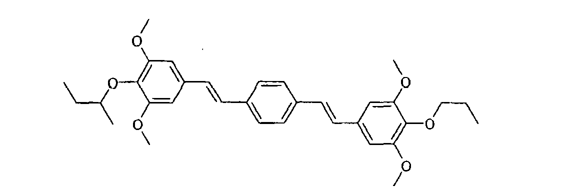 |
| 47 wt.% |

• Texapon 842: sodium octylsulphate commercially available from COGNIS.
• Emulsogen TS160: a 2,4,6-tris-(1-phenylethyl)-polyglycolether having approximately 15 ethyleneoxyde units, commercially available from CLARIANT.
• Dowanol PM: methoxy propanol, commercially available from DOW CHEMICAL COMPAGNY.
• Dowanol PPH: phenoxy isopropanol, commercially available from DOW CHEMICAL COMPAGNY.
• MEK: methylethylketone.
• Triethanolamine, commercially available from BASF.
• Dextrine, commercially available from ROQUETTE FRERES.
• H₃PO₄, commercially available from MERCK.
• KOMA30 NEU, copolymer consisting of 64 mol% vinyl butyral - 26 mol% vinyl alcohol - 2 mol% vinyl acetate - 8 mol% esterification product of vinylalcohol and trimellitic acid anhydride.

### Support

A 0.3 mm thick aluminum foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15g/l HCl, 15g/l SO4²⁻ ions and 5g/l Al³⁺ ions at a temperature of 37°C and a current density of about 100 A/dm². Afterwards, the aluminum foil was desmutted by etching with an aqueous solution containing 5.5 g/l NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and post-treated for 3 seconds (by spray) with a solution containing 2.2 g/l PVPA at 70°C, rinsed with demineralised water for 1 seconds and dried at 120°C for 5 seconds.

The support thus obtained was characterised by a surface roughness Ra of 0.35-0.4 µm (measured with interferometer NT1100) and had an anodic weight of 3.0 g/m².

### Photopolymerizable layer

The photopolymerizable layer was prepared by coating a solution of the ingredients listed in Table 1 in a DOWANOL PM/MEK (62/38) mixture on the above described support. The wet coating thickness was 20 µm. After drying, a dry coating weight of 1.2 g/m² was obtained. The dry amounts after coating of the ingredients are shown in Table 1.

**Table 1**

| Ingredients | g/m² |
|---|---|
| Tegoglide 410 | 0.0012 |
| Sensitizer | 0.0516 |
| FST426R | 0.1369 |
| Mono Z1620 | 0.4931 |
| Heliogene Blue | 0.0960* |
| Hostanox 03 | 0.0006 |
| HABI | 0.0780 |
| MBT | 0.0036 |
| KOMA30 NEU | 0.3390 |

| | |
|---|---|
| * pigment + dispersants | |

### Preparation of the overcoat layer

The overcoat layer, also referred to as the top layer, was applied on the photopolymerizable layer described above from an aqueous solution, containing the ingredients listed in Table 2. The wet coating thickness was 45 µm. After drying at 110°C for 2 minutes a dry coverage weight of 1.16 g/m² was obtained. The dry amounts, after coating, of the ingredients of the overcoat layer are shown in Table 2.

**Table 2**

| Ingredients | g/m² |
|---|---|
| PVA-1 | 0.7106 |
| PVA-2 | 0.4284 |
| Acticide | 0.0020 |
| Advantage S | 0.0116 |
| Lutensol A8 | 0.0089 |

### Processing of the printing plate precursors

The above described printing plate precursor was developed in an automatic processor unit having a pre-heat section, an optional cooling section, a development section and a drying section. To simulate practical conditions, every 2 seconds a printing plate precursor was processed. These conditions simulate, for example, practical conditions used in the newspaper business. The dip tank of the development section was filled with the developing solution having the composition as outlined in Table 3.

**Table 3**

| Ingredients | g/l |
|---|---|
| Texapon 842 | 9.00 |
| Emulsogen TS160 | 17.50 |
| H₃PO₄ | 2.60 |
| Dowanol PPH | 10.00 |
| Triethanolamine | 7.40 |
| Dextrine | 25.00 |
| Water | 928.50 |
| pH | 6.5-7.5 |

At the start of the experiment, the temperature of the developer was room temperature.

In Table 4, the temperature of the developer is given as a function of the amount of printing plate precursors developed, both for an apparatus with an active and an inactive accelerated cooling section. Cooling in the cooling section was realized by blowing air having ambient temperature from outside the processor housing with an air knife over the printing plate precursors, between the pre-heat section and the development section. All precursors had a size of 745 mm x 605 mm and a thickness of 0.30 mm (the precursors were processed in the 605 mm direction). The amount of developer used was 40 liter, the processing speed was 1.2 m/min. The pre-heat temperature, measured on the back side of the precursors with strips available from Thermographic Measurements Ltd, was 110°C.

The dwell time between exit from the pre-heat section and entrance in the development section was 12 seconds.

**Table 4**

| # Printing plates processed | Temperature developing solution (°C) | |
|---|---|---|
| | Inactive cool section | Active cool section |
| 0 | 23.6 | 23.6 |
| 20 | 25.5 | 25.0 |
| 40 | 28.2 | 27.0 |
| 60 | 30.1 | 28.3 |
| 80 | 31.5 | 29.5 |
| 100 | 32.9 | 30.5 |
| 120 | 34.7 | 31.3 |

From Table 4 it is clear that the temperature of the developing solution increases upon processing of a substantial amount of precursors within a short time interval.

From Table 4 is also clear that the temperature of the developing solution rises to a lesser extent when an active cooling section is provided. Since lithographic properties depends on the temperature of the developing solution, a rise of the temperature to a lesser extent results in more consistent lithographic properties of the printing plate so obtained.

## Claims

1. A method of preparing a lithographic printing plate comprising the steps of:
- providing a lithographic printing plate precursor comprising a photopolymerizable coating provided on a hydrophilic support;
- image-wise exposing the precursor;
- pre-heating the exposed precursor;
- developing the exposed precursor in a gum solution; **characterized in that** after pre-heating and before developing the precursor an accelerated cooling of the precursor is carried out and the cooling does not essentially remove a part of the coating of the precursor.

2. The method according to claim 1 wherein the cooling is carried out by applying a fluid on the plate.

3. The method according to claim 2 wherein the fluid has a lower temperature than ambient temperature.

4. The method according to claims 2 or 3 wherein the cooling is carried out by a fluid flow on the top side of the plate or on the back side of the plate or on both.

5. The method according to any one of claims 2 to 4 wherein the fluid is air.

6. The method according to any one of claims 2 to 4 wherein the fluid is water, an organic solvent, liquid nitrogen, or dry-ice vapour.

7. The method according to claim 1 wherein the cooling is carried out by applying a cold solid on the plate.

8. The method according to claim 1 wherein the cooling is carried out by contact cooling.

9. The method according to any one of the preceding claims wherein the temperature of the gum solution changes not more than 10°C.

10. The method according to any one of the preceding claims wherein the pre-heat is carried out at temperatures between 60°C and 150°C.

11. The method according to any one of the preceding claims wherein the precursor is image-wise exposed with a laser having a wavelength of from 350 nm to 450 nm.

12. The method according to any one of the preceding claims wherein the precursor is image-wise exposed with a laser having a wavelength of from 750 nm to 1500 nm.

## Patentansprüche

1. Ein Verfahren zur Herstellung einer lithografischen Druckplatte, das folgende Schritte umfasst :
- Bereitstellen einer lithografischen Druckplattenvorstufe, umfassend eine auf einen hydrophilen Träger angebrachte fotopolymerisierbare Beschichtung,
- bildmäßige Belichtung der Vorstufe,
- Vorwärmung der belichteten Vorstufe,
- Entwicklung der belichteten Vorstufe in einer Gummierlösung, **dadurch gekennzeichnet, dass** nach Vorwärmung und vor Entwicklung der Vorstufe eine beschleunigte Abkühlung der Vorstufe vorgenommen wird und bei der Abkühlung im Wesentlichen keinen Teil der Beschichtung der Vorstufe entfernt wird.

2. Verfahren nach Anspruch 1, **dadurch gekennzeichnet, dass** die Abkühlung durch Anbringen einer Flüssigkeit auf die Platte erfolgt.

3. Verfahren nach Anspruch 2, **dadurch gekennzeichnet, dass** die Flüssigkeit eine Temperatur unter Umgebungstemperatur aufweist.

4. Verfahren nach den Ansprüchen 2 oder 3, **dadurch gekennzeichnet, dass** die Abkühlung durch einen Flüssigkeitsstrom auf die Oberseite der Platte, auf die Rückseite der Platte oder auf beides erfolgt.

5. Verfahren nach einem der Ansprüche 2 bis 4, **dadurch gekennzeichnet, dass** die Flüssigkeit Luft ist.

6. Verfahren nach einem der Ansprüche 2 bis 4, **dadurch gekennzeichnet, dass** die Flüssigkeit Wasser, ein organisches Lösungsmittel, Flüssigstickstoff oder Trockeneisdampf ist.

7. Verfahren nach Anspruch 1, **dadurch gekennzeichnet, dass** die Abkühlung durch Anbringen eines kalten Feststoffes auf die Platte erfolgt.

8. Verfahren nach Anspruch 1, **dadurch gekennzeichnet, dass** die Abkühlung durch Kontaktabkühlung erfolgt.

9. Verfahren nach einem der vorstehenden Ansprüche, **dadurch gekennzeichnet, dass** die Temperatur der Gummierlösung um nicht als 10°C variiert.

10. Verfahren nach einem der vorstehenden Ansprüche, **dadurch**
**gekennzeichnet, dass** die Vorwärmung bei einer Temperatur zwischen 60°C und 150°C erfolgt.

11. Verfahren nach einem der vorstehenden Ansprüche, **dadurch**
**gekennzeichnet, dass** die bildmäßige Belichtung der Vorstufe mittels eines Lasers mit einer Wellenlänge zwischen 350 nm und 450 nm erfolgt.

12. Verfahren nach einem der vorstehenden Ansprüche, **dadurch**
**gekennzeichnet, dass** die bildmäßige Belichtung der Vorstufe mittels eines Lasers mit einer Wellenlänge zwischen 750 nm und 1500 nm erfolgt.

## Revendications

1. Un procédé de préparation d'une plaque d'impression lithographique, comprenant les étapes ci-après :
- la mise à disposition d'un précurseur d'une plaque d'impression lithographique, comprenant un revêtement photopolymérisable appliqué sur un support hydrophile,
- l'exposition sous forme d'image du précurseur,
- le préchauffage du précurseur exposé,
- le développement du précurseur exposé dans une solution de gommage,
**caractérisé en ce qu'**après son préchauffage et avant son développement, le précurseur est soumis à un refroidissement accéléré et que le refroidissement ne provoque pas essentiellement d'élimination d'une part du revêtement du précurseur.

2. Procédé selon la revendication 1, **caractérisé en ce que** le refroidissement consiste à appliquer un liquide sur la plaque.

3. Procédé selon la revendication 2, **caractérisé en ce que** la température du liquide est inférieure à la température ambiante.

4. Procédé selon les revendications 2 ou 3, **caractérisé en ce que** le refroidissement s'effectue à l'aide d'un flux de liquide appliqué sur la face supérieure de la plaque, sur la face dorsale de la plaque ou sur les deux faces.

5. Procédé selon l'une quelconque des revendications 2 à 4, **caractérisé en ce que** le liquide est de l'air.

6. Procédé selon l'une quelconque des revendications 2 à 4, **caractérisé en ce que** le liquide est de l'eau, un solvant organique, de l'azote liquide ou de la vapeur de glace sèche.

7. Procédé selon la revendication 1, **caractérisé en ce que** le refroidissement consiste à appliquer une matière solide froide sur la plaque.

8. Procédé selon la revendication 1, **caractérisé en ce que** le refroidissement est un refroidissement par contact.

9. Procédé selon l'une quelconque des revendications précédentes, **caractérisé en ce que** la température de la solution de gommage ne varie pas de plus de 10°C.

10. Procédé selon l'une quelconque des revendications précédentes, **caractérisé en ce que** le préchauffage s'effectue à une température comprise entre 60°C et 150°C.

11. Procédé selon l'une quelconque des revendications précédentes, **caractérisé en ce que** l'exposition sous forme d'image du précurseur s'effectue à l'aide d'un laser émettant à une longueur d'onde comprise entre 350 nm et 450 nm.

12. Procédé selon l'une quelconque des revendications précédentes,
**caractérisé en ce que** l'exposition sous forme d'image du précurseur s'effectue à l'aide d'un laser émettant à une longueur d'onde comprise entre 750 nm et 1500 nm.
